**Europäisches Patentamt**

**European Patent Office**

**Office européen des brevets**

(11) Numéro de publication: **0 327 554 B1**

# (12) FASCICULE DE BREVET EUROPEEN

(45) Date de publication de fascicule du brevet: **07.01.93**  (51) Int. Cl.⁵: **H01F 7/02**, G01R 33/38

(21) Numéro de dépôt: **87906825.2**

(22) Date de dépôt: **13.10.87**

(86) Numéro de dépôt internationale :
**PCT/FR87/00391**

(87) Numéro de publication internationale :
**WO 88/02922 (21.04.88 88/09)**

(54) **BLOC MAGNETIOUE A AIMANTATION AJUSTABLE POUR LA PRODUCTION D'UN CHAMP MAGNETIOUE PERMANENT DANS UNE ZONE D'INTERET.**

(30) Priorité: **17.10.86 FR 8614416**

(43) Date de publication de la demande:
**16.08.89 Bulletin 89/33**

(45) Mention de la délivrance du brevet:
**07.01.93 Bulletin 93/01**

(84) Etats contractants désignés:
**DE GB IT NL**

(56) Documents cités:
**EP-A- 0 170 318**
**CH-A- 306 175**

(73) Titulaire: **GENERAL ELECTRIC CGR S.A.**
**100, rue Camille-Desmoulins**
**F-92130 Issy les Moulineaux(FR)**

(72) Inventeur: **AUBERT, Guy**
**26, cours de la Libération**
**F-38100 Grenoble(FR)**

(74) Mandataire: **Ballot, Paul Denis Jacques**
**Cabinet Ballot-Schmit, 7, rue le Sueur**
**F-75116 Paris(FR)**

# Description

La présente invention est due au Service National des Champs Intenses, Directeur M. Guy AUBERT, et elle a pour objet un bloc magnétique à aimantation ajustable pour la production d'un champ magnétique permanent dans une zone d'intérêt. Elle trouve son application particulièrement dans le domaine médical où des aimants sont utilisés dans des expériences d'imagerie par résonance magnétique nucléaire. Elle peut aussi trouver son application dans tous les domaines où des distributions particulières d'un champ d'induction magnétique sont requises.

Dans le domaine de l'imagerie par résonance magnétique il est nécessaire de placer les objets à imager, les patients, dans un champ d'induction magnétique élevé-couramment de 0,1 à 1,5 Tesla - homogène et uniforme -quelques parties par million de variation - dans un grand volume d'intérêt - couramment une sphère de 50 cm de diamètre. Plusieurs classes de générateurs de champ magnétique ont été developpées jusqu'à présent. Les principales sont : les aimants supraconducteurs, les aimants dits resistifs et les aimants permanents. Les aimants à conducteurs supraconducteurs, qui permettent d'obtenir des champs très intenses, sont de réalisation et d'exploitation très couteuses à cause de leur technologie délicate. Ils sont en outre consommateurs de produits cryogéniques rares et chers : comme l'hélium liquide. Les aimants dits résistifs, avec ou sans matériau magnétique associé, consomment une assez forte énergie électrique. Ils posent en outre des problèmes thermiques d'évacuation de la chaleur produite quand on veut dépasser un champ de 0,2 Tesla. Les aimants permanents ont pas contre de nombreux avantages.

En particulier ils ne nécessitent pas d'alimentation d'énergie pour produire le champ. Ils ne courrent donc pas le risque de dérive de leur valeur du champ due à la dérive de ces alimentations ou du système d'évacuation de la chaleur dissipée. Ils ne nécessitent pas de moyens de refroidissement particuliers avec des techniques de régulation sophistiquées de l'écoulement des fluides cryogéniques. Leur température de fonctionnement est aisément stabilisée. Ils sont en outre particulièrement adaptés à la réalisation de structures ou de systèmes produisant un champ principal transverse, c'est à dire perpendiculaire à la direction d'introduction des objets, des patients, dans l'aimant. Cette disposition est très favorable à la réalisation d'antennes réceptrices des signaux de résonance à haut gain et très uniformes. Le principal inconvénient des aimants permanents réside dans leur poids et leur coût dès que l'on veut produire un champ suffisant pour l'imagerie par RMN.

Il est donc particulièrement important d'utiliser au mieux les capacités d'un matériau donné, c'est à dire de n'employer que la quantité minimum de matériau nécessaire à la réalisation de l'objectif fixé. Par ailleurs les conditions d'homogénéité du champ dans la zone d'intérêt sont extrèmement délicates à remplir et il est indispensable qu'en tout point de la structure l'aimantation du matériau soit bien celle que l'on a souhaité réaliser théoriquement. La principale difficulté rencontrée est due au fait que les blocs magnétiques aimantés qui produisent le champ d'induction magnétique recherché dans la zone d'intérêt produisent une excitation magnétique $\vec{H}$ dans tout l'espace et donc également en tout point à l'intérieur du matériau lui même. Comme il est bien connu de l'homme de métier, cette excitation magnétique $\vec{H}$ en un point du matériau où l'aimantation est $\vec{M}$ est tres généralement "démagnétisante", c'est à dire qu'elle peut être décomposée en une composante perpendiculaire a $\vec{M}$, soit $H_l$, et une composante parallèle à $\vec{M}$, soit $H_{//}$, qui est dirigée en sens inverse de $\vec{M}$. Le matériau doit être choisi et utilisé de façon telle qu'il conserve au mieux l'aimantation qu'on lui a conférée au cours du processus dit d'aimantion qui correspond à l'application d'une excitation magnétique suffisante ayant la direction et le sens que l'on veut donner à $\vec{M}$.

Si la structure de l'aimant final est telle qu'en certaines zones occupées par le matériau la composante $H_l$ n'est pas très faible, il est nécessaire d'utiliser en ces endroits un matériau dit à grande anisotropie, c'est à dire un matériau qui tend à conserver très fortement son aimantation alignée suivant une direction privilégiée dite direction de facile aimantation ou direction d'anisotropie. Cette propriété du matériau est caractérisée schématiquement par son champ d'anisotropie $H_A$ qui permet d'estimer la déviation angulaire $\epsilon$ du vecteur aimantation $\vec{M}$ de la direction d'anisotropie suivant laquelle il a été établi provoquée par une excitation pérpendiculaire $H_l$ suivant la relation $\epsilon$ sensiblement égal à $H_l/H_A$, à condition que $H_l$ soit trés inférieur à $H_A$. Parmi les matériaux commerciaux à grande anisotropie on peut citer les Ferrites de Baryum ou de Strontium, les composés de Terres Rares et de Cobalt comme SmCo5, et des matériaux apparus plus récemment à base de Fer, Néodyme et Bore.

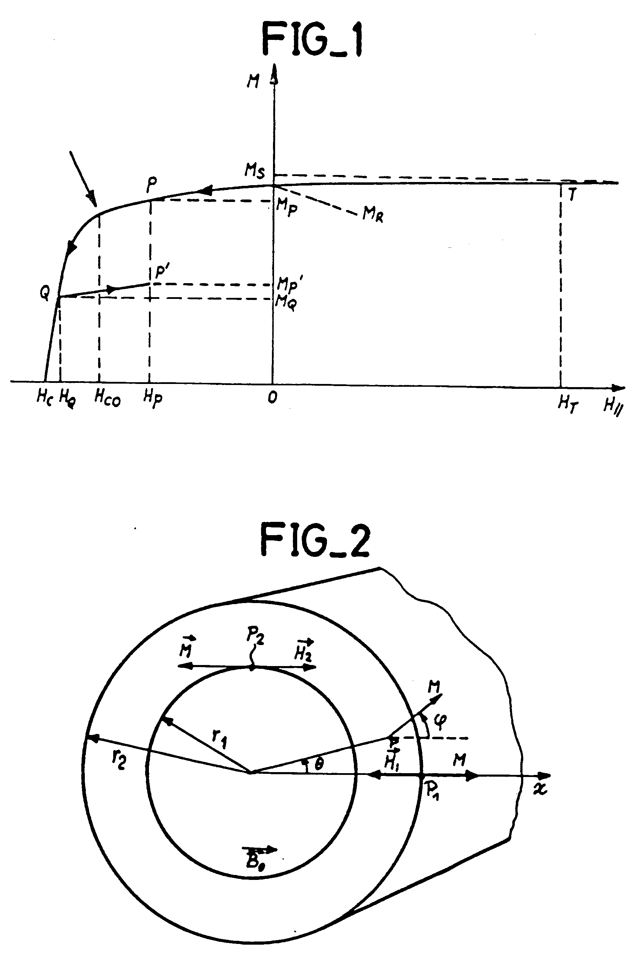

Le problème de la perturbation de l'aimantation par une excitation perpendiculaire étant supposé résolu, si nécessaire par l'utilisation d'un matériau à champ d'anisotropie suffisant, il n'en demeure pas moins que la composante parallèle $H_{//}$ est également de nature à écarter la grandeur de l'aimantation $\vec{M}$ de la valeur souhaitée. La courbe de la figure 1 rappelle les caractéristiques essentielles des matériaux de ce point de vue. Un élément de volume ayant eu, par application d'un champ extérieur convenable, son excitation magnétique interne, amenée à la valeur $H_T$ a été aimanté à une valeur proche de son aimantation à saturation $M_S$. Cet élément de volume se trouve, après suppression du champ extérieur et mise en place dans l'ensemble du dispositif, soumis à une excitation interne généralement négative (démagnétisante), de valeur par exemple $H_P$, qui lui confère une aimantation $M_P$ correspondant au point P d'une courbe caractéristique du matériau dite courbe de désaimantation. Ceci se produit à la condition toutefois que le matériau n'ait jamais été soumis depuis l'application de l'excitation d'aimantation $H_T$ à une excitation inférieure à $H_P$. En effet, si tel était le cas et que l'élément de volume considéré ait connu à un instant quelconque (par exemple au cours du montage et à cause de l'influence d'autres pièces du dispositif) une excitation $H_Q$ inférieure à $H_P$ et qu'il se trouve ultérieurement connaître une excitation supérieure à $H_Q$, par exemple de nouveau $H_P$, il ne retrouverait pas l'aimantion $M_P$ mais une aimantion inférieure $M_{P'}$ correspondant à un point P' situé non pas sur la courbe de désaimantation mais à l'intérieur de celle-ci dans le deuxième quadrant. On dit que le point de fonctionnement de l'élément de volume de matériau est "remonté" de Q en P' en suivant une courbe de pente légèrement positive dite "droite de recul" car elle est en général sensiblement rectiligne. Cette propriété est quelquefois utilisée pour obtenir avec une certaine excitation interne par exemple $H_P$, une aimantation plus faible que l'aimantation maximum possible $M_P$. Ce "réglage" de l'aimantation se fait généralement par application d'un champ extérieur en sens inverse du champ d'aimantion initial et choisi judicieusement de façon telle qu'en "remontant" ensuite suivant la "droite de recul" on se retrouve avec la valeur d'aimantation souhaitée. Ce procédé est d'une part délicat à mettre en oeuvre et d'autre part peu satisfaisant du point de vue économique puisqu'il n'utilise pas un matériau magnétique, onéreux, au maximum de ses possibilités C'est un des avantages de l'invention qui sera discuté plus loin de présenter une alternative à ce procédé d'ajustement.

Pour bien appréhender l'ensemble des potentialités de l'invention il reste à rappeler quelques caractérisitiques communes à tous les matériaux pour aimants permanents. L'excitation magnétique $H_c$ telle que pour $-H_c$ on obtient une aimantation nulle est appelée "champ coercitif intrinsèque" du matériau alors que l'aimantation $M_R$ correspondant à une excitation interne nulle est appelée "aimantation rémanente". La courbe de désaimantation est marquée par l'existence d'un coude plus ou moins prononcé suivant les matériaux (flèche de la figure 1) qui indique approximativement en dessous de quelle valeur de l'excitation interne il ne faut pas descendre si l'on ne souhaite pas diminuer de façon importante et irréversible l'aimantation de l'élément de volume considéré. Cette excitation de coupure $-H_{co}$, conduisant à une aimantation peu inférieure à $M_R$, est typiquement de l'ordre de $-0,7 H_c$. Certaines structures d'aimants permanents très intéressantes ne sont pratiquement pas réalisables (ou conduisent à des déboires si on les réalise) car cette limite se trouve malheureusement dépassée avec les matériaux existants. L'invention propose également une solution à ce problème en permettant de garantir qu'en aucun élément de volume du matériau on ne dépassera une limite préalablement fixée pour l'excitation magnétique interne, connaissant les propriétés du matériau utilisé.

On comprendra mieux la réalité du problème en examinant un exemple particulier. Des structures d'aimants permanents produisant un champ magnétique uniforme dans un volume relativement élevé on été décrites dans l'état de la technique. En particulier H. Zijlstra, dans un article intitulé "Permanent magnet system for NMR tomography", édité par le Philips Journal of Research, volume 40 n° 5 de 1985 pages 259 et suivantes, ainsi que dans une demande de brevet européen n° 00170318 déposée le 08 Juillet 1985, publiée le 05 Février 1986, et intitulée "Nuclear magnetic resonance aparatus with a permanent magnet", a décrit une structure d'aimant cylindrique produisant un champ uniforme transverse (pour peu que la longueur du cylindre soit infinie). Il a pu établir que le champ $B_0$ qui régnait à l'intérieur de ce cylindre pouvait s'écrire en théorie :

$$B_0 = \mu_0 \, M \, \mathrm{Log} \, (r_2 / r_1).$$

Dans cette formule M représente l'aimantation du matériau magnétique utilisé, supposée de module constant, et faisant en tout point P, repéré par un angle $(0x, OP) = \theta$ avec une demie droite Ox, un angle $\phi = 2\theta$ avec Ox, comme indiqué sur la figure 2. Par ailleurs $r_1$ et $r_2$ sont les rayons, respectivement intérieur et extérieur, du cylindre constituant l'aimant. Le coefficient $\mu_0$ représente la perméabilité du vide.

Il en a été déduit que, sans restriction de poids, les aimants permanents à structure cylindrique "$\phi = 2\theta$", approximés par des constructions plus ou moins polygonales, ou plus ou moins prismatiques, peuvent produire des champs aussi grands que l'on veut. En effet il suffit théoriquement d'augmenter le rayon extérieur $r_2$ du cylindre pour augmenter en correspondance $B_0$. Cependant les différents essais qui on été effectués, mettant en pratique cette théorie, montrent que jusqu'à maintenant les résultats obtenus pour la valeur du champ ne correspondent pas à ce que la théorie prévoit.

L'origine de ces difficultés est à rechercher dans les problèmes d'excitation démagnétisante rappelés plus haut. Nous limiterons la discussion à deux éléments de volume particuliers, $P_1$ et $P_2$ de la figure 2. On peut très facilement établir que, si l'aimantion a bien la configuration souhaitée dans le cylindre (même module, $\phi = 2\theta$), on a en $P_1$ : $H_{1//} = -M$ ($\vec{M}$ est parallèle à Ox et de même sens) et en $P_2$ $H_{2//} = H_0 = B_0/\mu_0 = M\ Log\ (r2/r1)$ ($\vec{M}$ est ici parallèle à Ox mais de sens contraire). Dans les deux cas $H_{//}$ est mesuré algébriquement suivant 0x, donc dans les deux cas est en sens inverse de $\vec{M}$ ($H_{//}$ est une excitation démagnétisante). On conçoit donc qu'une telle structure n'est réalisable pratiquement que si l'on dispose d'un matériau dont l'excitation de coupure $H_{co}$ est supérieure à $M_R$ et ce quel que soit le champ $B_0$ souhaité (condition au point $P_1$) si l'on veut utiliser au mieux le matériau, c'est à dire donner au module de son aimantion la plus grande valeur possible, donc voisine de $M_R$. Même si l'on dispose, ce qui est déjà exceptionnel, d'un tel matériau (quelques nuances de Terres Rares - Cobalt par exemple) on ne pourra pas augmenter autant que l'on veut $r_2$ donc $B_0$ puisqu'il faudra que l'excitation démagnétisante égale à $B_0/\mu_0$ reste inférieure à $H_{co}$ (condition au point $P_2$). Cette discussion a été volontairement simplifiée et limitée à ces deux points particuliers mais elle est cependant bien représentative du problème rencontré dans la conception d'une structure d'aimant permanent.

L'invention propose une solution à ce problème en préconisant l'emploi d'un matériau composite dont la partie active est toujours utilisée au mieux de ses possibilités, mais dont la composition abaisse dans une proportion souhaitée l'aimantation équivalente. Ce résultat est obtenu en conservant par contre le champ coercitif $H_c$ et l'excitation de coupure $H_{co}$ du matériau actif de base. Ainsi, en reprenant l'exemple précédent, si l'on dispose d'un matériau de base dont $H_{co}$ n'est pas supérieur à $M_R$, on choisira une composition dont l'aimantation réamanente equivalente $M_{Req}$ devient inférieure à $H_{co}$. Il suffira ensuite de ne pas dépasser un rayon $r_2$ tel que $B_0/\mu_0$, égal à $M_{Req}\ Log\ (r_2/r_1)$, reste inférieur à $H_{co}$. On ne peut donc pas réaliser un champ aussi grand qu'on le veut mais la structure théorique devient réalisable pratiquement.

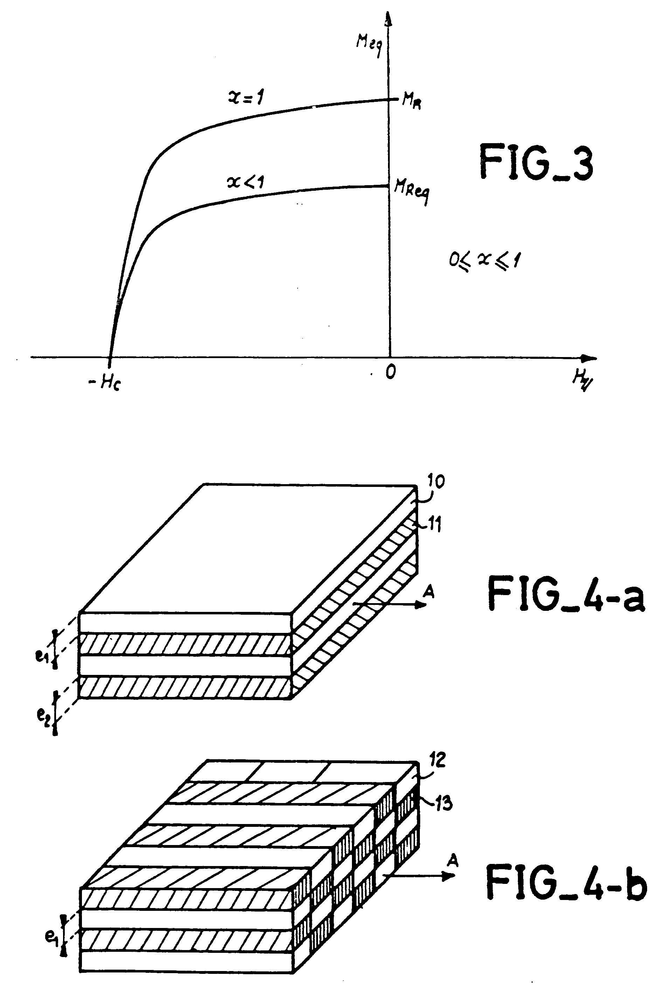

Il faut bien noter que cette réduction de l'aimantation ne se fait pas par désaimantation du matériau, mais par réduction du volume de matériau actif, toujours utilisé au maximum de ses possibilités. Ce matériau actif n'est qu'une certaine proportion, inférieure à 1, du volume occupé par le composite. La réduction est donc faite de manière bien plus économique tout en lui assurant une bien meilleure reproductibilité. En effet il suffit pour l'obtenir d'appliquer le champ suffisant d'aimantation au composite sans avoir à appliquer, comme dans le cas du matériau originel partiellement désaimanté, un champ de désaimantation très difficile à ajuster. De plus, la possibilité de réaliser à partir d'un matériau de base unique, un matériau composite à courbe de désaimantation ajustable, ouvre un domaine nouveau pour l'invention de nouvelles structures où l'on met à profit cette possibilité d'ajustement. La figure 3 montre une des courbes d'une famille de courbes en nombre illimité que l'on peut obtenir. Les courbes se déduisent par une affinité de rapport x, $0 \leq x \leq 1$ de la courbe (x = 1) de désaimantation du matériau de base. Enfin dans le cas d'utilisation d'un matériau de base anisotrope, le procédé de fabrication du composite conserve également intégralement les propriétés d'anisotropie. C'est à dire que le composite a le même champ d'anisotropie $H_A$ que le matériau de base.

L'invention concerne en conséquence un bloc magnétique à aimantation ajustable pour la production d'un champ magnétique permanent dans une zone d'intérêt, selon la revendication 1.

L'invention sera mieux comprise à la lecture de la description qui suit et à l'examen des figures qui l'accompagnent. Celles ci ne sont données qu'à titre indicatif et nullement limitatif de l'invention. Les figures montrent :

- figure 1 à 2 : l'état de la technique;
- figure 3 : des courbes de désaimantation d'un matériau composite selon l'invention;
- figure 4a et 4b : des exemples de réalisation d'un bloc composite selon l'invention;
- figure 5 : un exemple d'utilisation d'un matériau composite selon l'invention dans une application d'imagerie par RMN.

Les figures 4a et 4b présentent deux réalisations possibles parmis d'autres, d'un bloc magnétique selon l'invention. L'aimantation y est réduite, par exemple de moitié, par rapport à l'aimantation d'un matériau de base 10 représenté sans hachure. Ce matériau magnétique est présent sous forme de plaques telles que 10 (figure 4a) ou de barres telles que 12 (figure 4b) séparées les unes des autres par un matériau non magnétique respectivement des plaques 11, et des barres 13. Ce matériau non magnétique peut être par exemple du PVC ou de la résine epoxy. Les plaques 10, 11 ou les barres 12, 13 peut être collées ensembles avec une colle ou une résine appropriée pour assurer la rigidité de l'ensemble. La construction d'un bloc magnétique peut aussi être obtenue en maintenant les extrémités des plaques ou des barres dans des entretoises. D'une manière préférée, pour assurer la rigidité du bloc on peut couler de la résine epoxy entre les plaques, ou les barres, et les entretoises. La section des plaques ou des barres, mesurées perpendiculairement à la direction d'aimantation A (qui est donc nécessairement la direction d'anisotropie pour un matériau anisotrope), peut être de forme quelconque (rectangulaire dans le cas des figures 4a et 4b).

Suivant cette direction A, pour des raisons de commodité de fabrication industrielle, les plaques ou barres peuvent être constituées de plusieurs éléments mis bout à bout. Mais il est alors impératif de ne créer aucun espace physiquement mesurable entre ces éléments. Pratiquement l'espace entre ces éléments ne devraient pas dépasser un dixième de milimètre. Pour ce qui concerne les dimensions des sections des éléments (plaque ou barre) suivant la direction perpendiculaire à la direction d'aimantation, l'une au moins de ces dimensions (épaisseur de la plaque, diamètre d'une barre de section circulaire, etc...) doit être suffisamment petite. Typiquement elle doit être au plus du 1/10 ou du 1/20 du rayon de la sphère d'intérêt où doit régner l'induction magnétique produite par cet aimant. La courbe de désaimantation d'un bloc magnétique ainsi constitué se déduit de celle du matériau de base comme indiqué plus haut à la figure 3 avec l'affinité x. Cette affinité est égale au rapport entre l'aire de la section de matériau magnétique et l'aire totale de la section perpendiculaire à la direction d'aimantation.

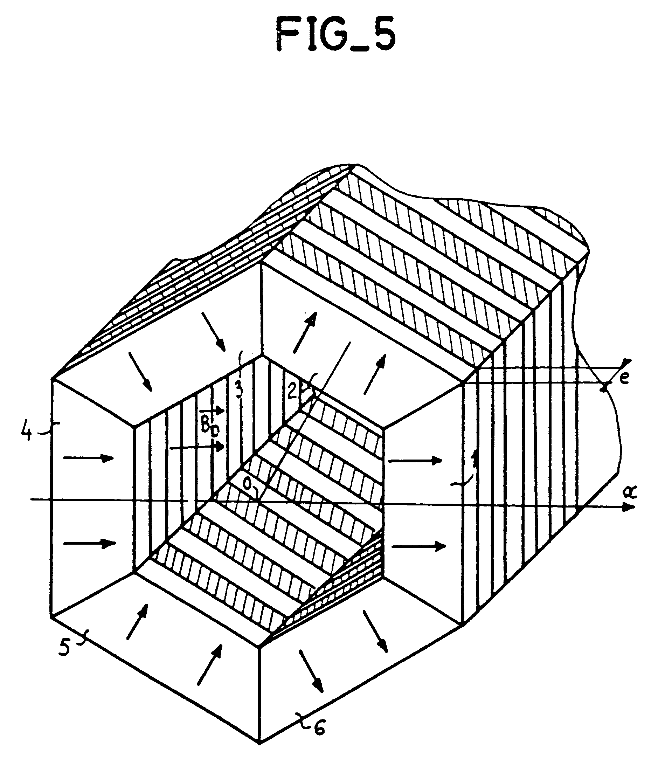

La figure 5 illustre l'utilisation de tels blocs magnétiques dans une structure d'un aimant, décrite par ailleurs dans une autre demande de brevet déposée le même jour par le demandeur. Un assemblage de blocs prismatiques 1 à 6 constitue une structure cylindrique de section polygonale régulière (ici une couronne hexagonale). Chaque prisme de section trapézoïdale à une aimantation dirigée parallèlement au rayon qui définit la position de son plan médian. La valeur de cette aimantation est proportionnelle au cosinus de l'angle de repérage de ce rayon avec un axe 0x. Les angles définissant la position des blocs sont donc multiples de 60° et conduisent donc à des proportions 1/2 puisque cos 60° est égal à 1/2. Dans la demande de brevet ainsi évoquée, on montre que cette distribution d'aimantation est susceptible de provoquer l'existence d'un champ $B_0$ uniforme et transverse à l'intérieur du cylindre. On peut réaliser la structure de l'aimant avec un matériau magnétique qui constitue entièrement les blocs 1 et 4, alors que les blocs 2, 3, 5 et 6 sont réalisés avec un composite utilisant ce même matériau et un matériau non magnétique dans des proportions respectivement 1/2 et 1/2. Par exemple cette structure peut être réalisée avec un seul type de plaques trapézoïdales de matériau magnétique. L'épaisseur e de ces plaques est de l'ordre de 1 cm pour un diamètre d'accès à l'intérieur du cylindre de l'ordre de quelques dizaines de centimètres. Les plaques sont aimantées dans leur plan, perpendiculairement aux deux côtés parallèles du trapèze. Les blocs 1 et 4 sont constitués par des empilements jointifs de ces plaques alors que les blocs 2, 3, 5, et 6 sont constitués par des empilements alternés de ces plaques magnétiques aimantées avec des plaques de même dimension mais en matière non magnétique. Dans l'exemple étudié on verifie donc que pour réaliser les blocs 2, 3, 5 et 6 on a utilisé deux fois moins de matériau magnétique que si l'on avait réalisé, pour ces blocs, des blocs identiques à 1 et 4, mais partiellement désaimantés par application d'un champ convenable pour leur conférer une aimantation réduite de moitié.

Signalons enfin la possibilité qu'offre l'invention pour rattraper des différences toujours possibles entre diverses fabrications d'un matériau donné. Il est en effet courant industriellement de constater des différences de plusieurs pourcents dans les propriétés magnétiques de divers lots d'un même matériau. La propriété de faire varier, de façon continue, l'épaisseur des plaques où les dimensions des barres des matériaux magnétiques et des matériaux non magnétiques utilisés permet de réaliser des blocs composites identiques à aimantation équivalente égale même si les matériaux magnétiques constituant ne le sont pas. Ceci peut se révéler être un avantage déterminant pour la réalisation d'aimants permanents à grande homogénéité.

En conclusion, la valeur absolue $| H_d |$ de l'excitation démagnétisante qui doit régner en un lieu donné doit être inférieure à l'excitation de coupure du matériau magnétique utilisé. Comme cette excitation démagnétisante est liée à l'aimantation équivalente $M_{Req}$ ($M_{Req} = M_R$ si x = 1) du matériau lui même, il convient de régler cette aimantation équivalente de manière à ce que $H_d$ devienne inférieure à $H_{co}$. Deux cas peuvent se produire. Dans un premier cas $H_d$ est déjà inférieure à $H_{co}$ : le matériau magnétique peut être employé seul. Dans un deuxième cas l'emploi de ce matériau seul conduit à une excitation démagnétisante trop forte, et il convient de réduire la proportion de ce matériau magnétique pour qu'il en résulte une nouvelle excitation démagnétisante inférieure à la limite $H_{co}$. La proportion est alors égale au rapport des excitations démagnétisantes nouvelles et anciennes : c'est à dire au plus égale au rapport de l'excitation de coupure $H_{co}$ à cette excitation démagnétisante $H_d$ à éviter. Autrement dit, dans l'exemple cité de l'état de la technique, en abaissant la proportion de matériau magnétique, partout, on obtient à coup sûr un champ $B_0$ uniforme (mais de valeur réduite).

**Revendications**

1. Bloc magnétique (2) à aimantation ajustable pour la production d'un champ magnétique ($B_0$) permanent dans une volume d'intérêt, comportant des proportions déterminées de matériau aimantable (10) d'une manière permanente et de matériau non aimantable (11), caractérisé en ce que le matériau aimanté produisant une excitation dans ce volume d'intérêt et dans le lieu où ce matériau lui-même se trouve, cette excitation jouant dans cedit lieu une action démagnétisante, ce matériau aimantable étant aimanté selon une aimantation qui implique l'existence d'une excitation de coupure, correspondant au point d'irréversibilité de la magnetisation sur la courbe de magnetisation, cette excitation de coupure étant de nature à désaimanter le matériau si elle lui est appliquée, la proportion de matériau aimantable dans le bloc est telle que l'excitation démagnétisante (Hd) qui règne dans ce bloc est sensiblement inférieure ou égale à l'excitation de coupure ($H_{co}$) de ce matériau aimantable.

2. Bloc selon la revendication 1, caractérisé en ce que la proportion varie en fonction de la valeur du champ à produire dans la zone d'intérêt et de l'aimantation correspondante du bloc.

3. Bloc selon l'une quelconque des revendications 1 ou 2, caractérisé en ce qu'il comporte des morceaux (10, 12) présentant une aimantation de direction donnée (M), les morceaux étant de la matière constitutive du matériau aimantable, la direction (A) privilégiée par l'anisotropie magnétique de ces morceaux étant orientée, à l'endroit de ces morceaux, dans le sens de l'aimantation (M) à produire.

4. Bloc selon la revendication 3 caractérisé en ce qu'une dimension des morceaux ($E_1$) orthogonale au sens de l'aimantation (M), est sensiblement inférieure ou égale au dixième de la dimension de la zone d'intérêt (V).

5. Bloc selon la revendication 4, caractérisé en ce que cette dimension vaut de l'ordre du vingtième de la dimension de la zone d'intérêt.

6. Bloc selon l'une quelconque des revendications 1 à 2, caractérisé en ce que les matériaux aimantables et non aimantables sont présents sous forme de plaques (7, 8) accolées les unes contre les autres, la direction de l'aimantation (M) y étant parallèle aux plaques.

7. Bloc selon l'une quelconque des revendications 1 à 2 caractérisé en ce que les matériaux aimantables sont présents sous forme de barres (9), la direction de l'aimantation étant parallèle à la grande dimension des barres.

8. Bloc selon l'une quelconque des revendications 1 à 2 caractérisé en ce que le matériau aimantable est présent sous la forme de barres noyées dans un matériau non aimantable, la direction d'aimantation étant parallèle à la grande dimension des barres.

9. Bloc selon l'une quelconque des revendications 1 à 2 caractérisé en ce que le matériau aimantable est présent sous la forme de morceaux alignés les uns contre les autres dans le sens de l'aimantation à produire.

10. Bloc selon l'une quelconque des revendications 1 à 2 caractérisé en ce que le matériau aimantable est une ferrite.

11. Bloc selon l'une quelconque des revendications 1 à 2 caractérise, en ce que le matériau aimantable est un matériau à base de terres rares et de Cobalt.

12. Bloc selon l'une quelconque des revendications 1 à 2 caractérisé en ce que le matériau aimantable est un matériau à base de Fer-Néodyme-Bore.

**Claims**

1. Magnetic block (2) with adjustable magnetization for producing a permanent magnetic field ($B_O$) in a zone of interest, comprising given proportions of permanently magnetizable material (10) and of non-magnetizable material (11), characterized by the fact that the magnetized material, producing an excitation in this zone of interest and in the place where this material itself is situated, this excitation exerting a demagnetizing action in the said place, this magnetizable material being magnetized according to a magnetization which implies the existence of a cut-off excitation, corresponding to the irreversibility point of the magnetization on the magnetization curve, this cut-off excitation being of such a nature as to demagnetize the material if it is applied to it, the proportion of magnetizable material in the block is such that the demagnetizing excitation (Hd) prevailing in this block is substantially below or equal to the cut-off excitation (Hco) of the said magnetizable material.

2. Block in accordance with Claim 1, characterized by the fact that the proportion varies as a function of the value of the field to be produced in the zone of interest and of the corresponding magnetization of the block.

3. Block in accordance with either of Claims 1 or 2, characterized by the fact that it comprises pieces (10, 12) showing magnetization in a given direction (M), the pieces being of the same material as that which constitutes the magnetizable material, the direction (A) privileged by the magnetic anisotropy of these pieces being orientated, in the place corresponding to the said pieces, in the direction of the magnetization (M) to be produced.

4. Block in accordance with Claim 3, characterized by the fact that a dimension of the pieces (E₁) which is orthogonal to the direction of the magnetization (M) is substantially lower than or equal to one tenth of the dimension of the zone of interest (V).

5. Block in accordance with Claim 4, characterized by the fact that this dimension is of the order of one twentieth of the dimension of the zone of interest.

6. Block in accordance with either of Claims 1 and 2, characterized by the fact that the magnetizable and non-magnetizable materials are present in the form of plates placed against one another, the direction of the magnetization (M) being parallel to the plates.

7. Block in accordance with either of Claims 1 and 2, characterized by the fact that the magnetizable materials are present in the form of bars (9) , the direction of magnetization being parallel to the major dimension of the bars.

8. Block in accordance with either of Claims 1 and 2, characterized by the fact that the magnetizable material is present in the form of bars buried in a non-magnetizable material, the direction of magnetization being parallel to the major dimension of the bars.

9. Block in accordance with either of Claims 1 and 2, characterized by the fact that the magnetizable material is present in the form of pieces aligned against one another in the direction of the magnetization to be produced.

10. Block in accordance with either of Claims 1 and 2, characterized by the fact that the magnetizable material is a ferrite.

11. Block in accordance with either of Claims 1 and 2, characterized by the fact that the magnetizable material has rare earth and cobalt base.

12. Block in accordance with either of Claims 1 and 2, characterized by the fact that the magnetizable materials has an iron-neodyme-boron base.

**Patentansprüche**

1. Magnetischer Block (2) mit einstellbarer Magnetisierung zur Erzeugung eines permanenten Magnetfeldes (B₀) in einem Wirkbereich, mit in vorgegebenen Verhältnissen vorhandenen Mengen an magnetisierbarem (10) Material und an nicht magnetisierbarem Material (11), dadurch gekennzeichnet, daß das magnetisierte Material in diesem Wirkbereich und in dem Ort, wo dieses Material sich befindet, eine Erregung erzeugt, wobei diese Erregung in eben diesem Ort eine entmagnetisiernde Wirkung entfaltet, wobei das magnetisierbare Material gemäß einer Magnetisierung magnetisiert wird, die das Vorhandensein einer einer Stelle der Unumkehrbarkeit der Magnetisierung auf der Kurve der Magnetisierung entsprechenden Trennerregung andeutet, wobei diese Trennerregung so geartet ist, daß sie das Material entmagnetisiert, falls sie auf es wirkt, und wobei das Verhältnis der Menge an magnetisierbarem Material im Block so groß ist, daß die im Block wirkende entmagnetisierende Erregung (Hd) wesentlich geringer ist als die Trennerregung (Hco) des magnetisierbaren Materials oder dieser gleichkommt.

2. Block nach Anspruch 1, dadurch gekennzeichnet, daß das Mengenverhältnis gemäß dem Wert des im Wirkbereich zu erzeugenden Feldes und der entsprechender, Magnetisierung des Blockes schwankt.

3. Block nach einem der Ansprüche 1 und 2, dadurch gekennzeichnet, daß es eine vorbestimmte Richtung der Magnetisierung (M) aufweisende Teile (10 und 12) umfaßt, die aus dem das magnetisierbare Material konstituierenden Werkstoff bestehen, wobei die durch die magnetische Anisotropie dieser Mengen begünstigte Richtung (A) am Ort dieser Mengen gemäß der Richtung der zu erzeugenden Magnetisierung (M) ausgerichtet ist.

4. Block nach Anspruch 3, dadurch gekennzeichnet, daß eine senkrecht zu der Richtung der Magnetisierung (M) liegende Abmessung (E₁) im wesentlichen kleiner als ein Zehntel der Abmessung des Wirkbereiches (V) ist oder diesem gleichkommt.

5. Block nach Anspruch 4, dadurch gekennzeichnet, daß dieser Abmessung etwa einem Zwanzigstel der Abmessung des Wirkbereiches entspricht.

6. Block nach einem der Ansprüche 1 und 2, dadurch gekennzeichnet, daß die magnetisierbaren und die nichtmagnetisierbaren Materialien als miteinander verbundene Platten (7 und 8) vorliegen, wobei die Richtung der Magnetisierung (M) hier parallel zu der Richtung der Platten ist.

7. Block nach einem der Ansprüche 1 und 2, dadurch gekennzeichnet, daß die magnetisierbaren Materialien in Form von Stangen (9) vorhanden sind, wobei die Richtung der Magnetisierung parallel zu der größeren Abmessung der Stangen liegt.

8. Block nach einem der Ansprüche 1 und 2, dadurch gekennzeichnet, daß das magnetisierbaren Material in Form von im nichtmagnetisierbaren Material eingebetteten Stangen vorliegt, wobei die Richtung der Magnetisierung parallel zu der größeren Abmessung der Stangen liegt.

9. Block nach einem der Ansprüche 1 und 2, dadurch gekennzeichnet, daß das magnetisierbare Material in Form von in der Richtung der zu erzeugenden Magnetisierung relativ zueinander ausgerichteten Stücken vorliegt.

10. Block nach einem der Ansprüche 1 und 2, dadurch gekennzeichnet, daß das magnetisierbare Material in Form eines Ferrits vorliegt.

11. Block nach einem der Ansprüche 1 und 2, dadurch gekennzeichnet, daß das magnetisierbare Material ein Material auf der Basis von den Seltenen Erden und Kobalt ist.

12. Block nach einem der Ansprüche 1 und 2, dadurch gekennzeichnet, daß das magnetisierbare Material ein Material auf der Basis von Eisen, Neodymium und Bor ist.

# FIG_1

# FIG_2

FIG_3

FIG_4-a

FIG_4-b

# FIG_5